# EUROPÄISCHE PATENTSCHRIFT

(11) **EP 0 431 104 B1**
(45) Veröffentlichungstag und Bekanntmachung des Hinweises auf die Patenterteilung: **29.09.1993**
(21) Anmeldenummer: 90908462.6
(22) Anmeldetag: 22.05.1990
(51) Int. Cl.: H05K 13/04

(54) **MANIPULATORKOPF ZUR MANIPULATION VON MINIATURISIERTEN ELEKTRONISCHEN BAUELEMENTEN**
MANIPULATOR HEAD FOR MANIPULATING MINIATURIZED ELECTRONIC COMPONENTS
TETE MANIPULATRICE POUR MANIPULER DES COMPOSANTS ELECTRONIQUES MINIATURISES

(30) Priorität: 26.05.1989 DE 8906468 U
(43) Veröffentlichungstag der Anmeldung: 12.06.1991
(73) Patentinhaber: Fritsch, Adalbert, D-92280 Kastl (DE)
(72) Erfinder: Fritsch, Adalbert, D-92280 Kastl (DE)
(74) Vertreter: Tergau, Enno, Dipl.-Ing.
(86) Internationale Anmeldenummer: DE9000375
(87) Internationale Veröffentlichungsnummer: WO9014753

(56) Entgegenhaltungen:
- EP-A- 13 979
- DE-A- 3 721 226

## Beschreibung

Die Erfindung betrifft einen Manipulatorkopf für einen Handmanipulator oder eine halb- oder vollautomatische Bestückungsvorrichtung jeweils zur Manipulation von miniaturisierten elektronischen Bauelementen mit den im Oberbegriff des Anspruches 1 angegebenen Merkmalen.

Ein derartiger Manipulatorkopf ist beispielsweise aus DE-A-37 21 226 bekannt. Er dient zur Bestückung von Leiterplatten mit SMD-Bauelementen und weist einen Kopfträger, der mit einer Vakuumanschlußleitung und einer Vakuumdurchführung versehen ist, sowie eine mit der Vakuumdurchführung in Verbindung stehende Vakuum-Saugpipette am Kopfträger auf, an deren Saugöffnung das Bauelement während des Bestückungsvorganges unter Vakuumeinfluß gehalten ist.

Der neuartige Manipulatorkopf ist insbesondere für das Bestücken von Mehrschichtleiterplatten (MLCB = Multi-Layer-Circuit-Board) mit sogenannten Durchführungswiderständen in der neuartigen Insert/Inboard-Mount-Technologie (IMT) entwickelt worden. Die IMT ist eine Weiterentwicklung der Oberflächen-Montage von elektronischen Bauelementen (SMT) und wurde beispielsweise in der Fachzeitschrift für Elektronik-Fertigung und Test "produktronic", 11/1988, S. 56 vorgestellt. Sie basiert auf der Tatsache, daß bei Mehrschichtleiterplatten Durchkontaktierungen vorgenommen werden müssen, um die verschiedenen Leiterplattenebenen an entsprechenden Schaltungspunkten miteinander verbinden zu können. Diese Durchkontaktierungen können als Einsatzort für Bauteile und insbesondere Widerstände, verwendet werden. Diese sind zylindrisch ausgestaltet und weisen kappenförmige Anschlußkontakte auf ihrer Zylindergrund- bzw.

Deckfläche auf. Bei einer Anpassung der Widerstandslänge an die Dicke der Leiterplatte kann ein Durchführungswiderstand in einer Durchkontaktierungsbohrung eingesteckt und die Anschlußkontakte mit entsprechenden Leiterbahnen auf der Ober- und Unterseite der Leiterbahn verlötet werden. Der Durchführungswiderstand übernimmt also neben seiner eigentlichen Bauteilfunktion auch die Funktion der Durchkontaktierung.

Wie bereits in dem vorgenannten Artikel angesprochen wurde, ist der eigentliche Bestückungsvorgang - das Einstecken der äußerst kleinen Widerstände in die Durchkontaktierungsbohrung - problematisch. Die Widerstände weisen nämlich nur Abmessungen in der Größe von etwa 2 mm Länge und 1 mm Durchmesser auf. Weitere Probleme ergeben sich durch die Verpackung solcher Widerstände in sogenannten Magazingurten. Letztere bestehen aus einem Metallband mit eingedrückten Vertiefungen, in denen die Widerstände mit ihrer Rotationsachse parallel zur Bandebene einliegen. Zur Bestückung ist es also notwendig, den Widerstand kontrolliert aus der Magazingurtvertiefung zu entnehmen, um 90° um eine seiner Querachsen zu kippen und mit seiner Rotationsachse koaxial zur Bohrungsachse der Durchkontaktierungsbohrung in diese einzusetzen.

Ausgehend von den geschilderten Problemen liegt der Erfindung die Aufgabe zugrunde, einen Manipulatorkopf für einen Handmanipulator oder eine halb- oder vollautomatische Bestückungsvorrichtung anzugeben, mit dem die vorstehenden Manipulationen von miniaturisierten elektronischen Bauelementen einfach und zuverlässig vorgenommen werden können.

Die Lösung dieser Aufgabe ist in den kennzeichnenden Merkmalen des Anspruches 1 angegeben. Demnach ist auf der Vakuum-Saugpipette ein koaxial dazu verlaufendes Manipulationshilfsrohr relativ zur Saugpipette verschiebbar geführt, dessen Freiende in Aufnahmestellung für das Bauelement über die Saugöffnung der Saugpipette hinaussteht und dessen Rohröffnung zum Freiende hin ein sich trichterförmig öffnendes Innenprofil aufweist. Durch diese Ausgestaltung des Manipulatorkopfes ist es möglich, mit ihm an ein in der Vertiefung des Magazingurtes liegendes Bauteil seitlich heranzugehen. Durch die Saugwirkung der Saugpipette wird das Bauteil angesaugt. Durch das sich trichterförmig öffnende Innenprofil des Manipulationshilfsrohres kann sich das Bauteil während des Ansaugens beim Eintreten in die Rohröffnung des Manipulationshilfsrohres um eine Querachse drehen, bis es an der Saugöffnung der Vakuum-Saugpipette ansteht und zwar mit seiner Rotationsachse koaxial zur Saugpipetten-Längsachse. Damit ist das Bauteil bereits richtig für den Bestückungsvorgang angeordnet. Nach dem Verfahren des Manipulatorkopfes vom Magazingurt zur Sollposition vertikal über der Durchkontaktierungsbohrung wird das Bauteil mit seinem der Saugpipette abgewandten Ende in die Durchkontaktierungsbohrung eingeführt und mittels der Saugpipette eingeschoben. Hierbei kommt die Verschiebbarkeit des Manipulationshilfsrohres relativ zur Saugpipette zum Tragen, wodurch das Bauteil aus der sich über die Saugpipette zurückschiebenden Rohröffnung aus- und in die Durchkontaktierungsbohrung eingeschoben werden kann.

Die Ansprüche 2-5 geben vorteilhafte Weiterbildungen des sich trichterförmig öffnenden Innenprofils der Rohröffnung des Manipulationshilfsrohres an. Zur Vermeidung von Wiederholungen wird in diesem Zusammenhang auf das Ausführungsbeispiel verwiesen.

Durch die im Anspruch 6 angegebenen Verrundungen der Übergangsbereiche am Innenprofil des Manipulationshilfsrohres wird ein möglichst ungehindertes und reibungsarmes Einführen des Bauteils in die Rohröffnung des Manipulationshilfsrohres erzielt.

Anspruch 7 hat zum Ziel, daß das Bauelement in der Rohröffnung möglichst genau zentriert und unter möglichst geringem seitlichen Spiel sitzt. Diese Eigenschaft ist insbesondere für halb- oder vollautomatische Bestückungsvorrichtungen wichtig, da zwischen der automatisch vom Manipulator angefahrenen Sollposition für das Einstecken des Bauelementes in die Durchkontaktierungsbohrung und der eigentlichen Istposition des elektronischen Bauteils am Manipulatorkopf eine möglichst geringe Toleranz vorhanden sein muß.

Die Ansprüche 8-10 betreffen die relative Verschiebbarkeit des Manipulationshilfsrohres gegenüber der Saugpipette. Durch die begrenzte, zur Verfügung stehende Hubstrecke, die insbesondere etwa 80% der Überstehlänge des Manipulationshilfsrohres gegenüber der Saugöffnung der Saugpipette entspricht, wird das Bauteil selbsttätig in seine Soll-Längsposition in der Durchkontaktierungsbohrung bezüglich der Leiterplatte geschoben. Weiteres ist dem Ausführungsbeispiel zu entnehmen.

Die Ansprüche 11-14 kennzeichnen vorteilhafte Weiterbildungen der Lagerung des Manipulationshilfsrohres am Kopfträger. Besondere Erwähnung verdient hier Anspruch 13, wonach in der Führungshülse zwischen Kopfträger und Manipulationshilfsrohr ein Federelement, insbesondere eine Schraubendruckfeder, zur Beaufschlagung des Manipulationshilsrohres in Überstehrichtung angeordnet ist. Zum einen wird dadurch das Manipulationshilfsrohr für das Aufnehmen des Bauteils aus dem Magazingurt in seine voll gegenüber der Saugpipette ausgefahrene Aufnahmeposition verbracht. Zum anderen wird der Kopfträger über das Federelement beim Anstoßen des Stirnendes des Manipulationshilfsrohres an die Oberfläche des Magazingurtes bzw. der Leiterplatte durch die Abstützung des Federelementes beaufschlagt. Die dadurch auf den Kopfträger ausgeübte Kraft kann dazu verwendet werden, Schaltelemente im oder am Kopfträger zum Ein- bzw. Ausschalten des Vakuums zu betätigen.

Anspruch 14 dient einer Verbesserung der Führung des Manipulationshilfsrohres gegenüber der Saugpipette insbesondere im kopfträgerabseitigen Bereich dieser beiden Konstruktionsteile. Durch den Paßringaufsatz wird gleichzeitig eine Abdichtung des Abstandsspaltes zwischen der Innenwand des Manipulationshilfsrohres und der Außenwand der Saugpipette geschaffen, wodurch das Vakuum besonders verlustfrei auf das anzusaugende Bauteil übertragen wird. Damit ist dessen zuverlässige Entnahme aus dem Magazingurt und Halterung während des Verfahrens von der Bauteilaufnahmeposition zur Bestückungsposition gewährleistet.

Zur weiteren Verbesserung der Zentrierung der vom Manipulatorkopf gehandhabten Bauteile - insbesondere bei einer Verwendung des Manipulatorkopfes an vollautomatischen Bestückungsvorrichtungen - sind gemäß Anspruch 15 weitere Zentrierungs- und Klemmittel im Bereich der Überstehlänge der Innenöffnung des Manipulationshilfsrohres zur Festlegung der zu manipulierenden Bauelemente vorgesehen.

Weitere Merkmale, Eigenschaften und Vorteile der Erfindung werden aus der nachfolgenden Beschreibung klar, in der ein Ausführungsbeispiel des Erfindungsgegenstandes anhand der beiliegenden Figuren näher erläutert wird. Es zeigen:
- Fig. 1: einen Rotationsaxialschnitt durch Kopfträger, Saugpipette und Manipulationshilfsrohr des erfindungsgemäßen Manipulatorkopfes,
- Fig. 2: einen vergrößerten Rotationsaxialschnitt durch das Saugende der Anordnung gemäß Fig. 1,
- Fig. 3: eine perspektivische Darstellung eines Magazingurtes mit einliegenden Durchführungswiderständen und
- Fig. 4: eine schematische Darstellung der Manipulation eines Durchführungswiderstandes mit Hilfe des erfindungsgemäßen Manipulatorkopfes.

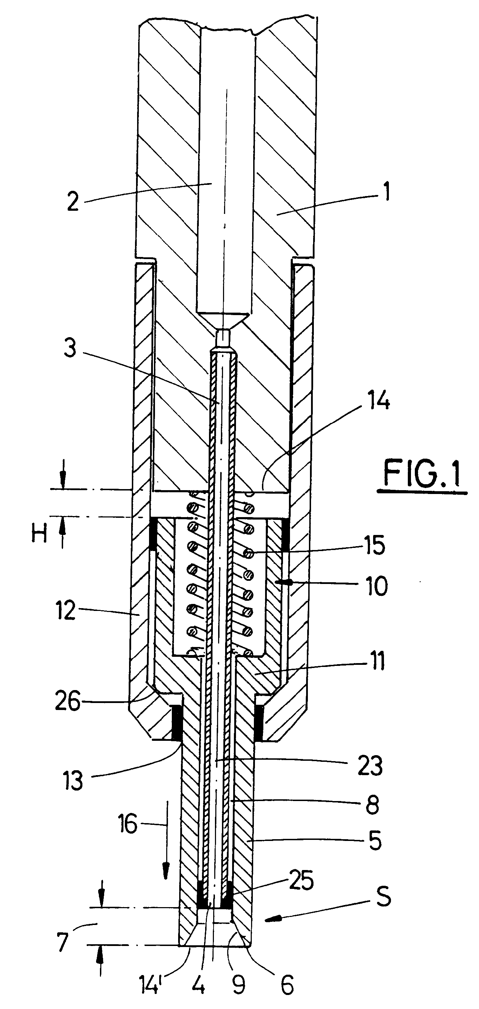

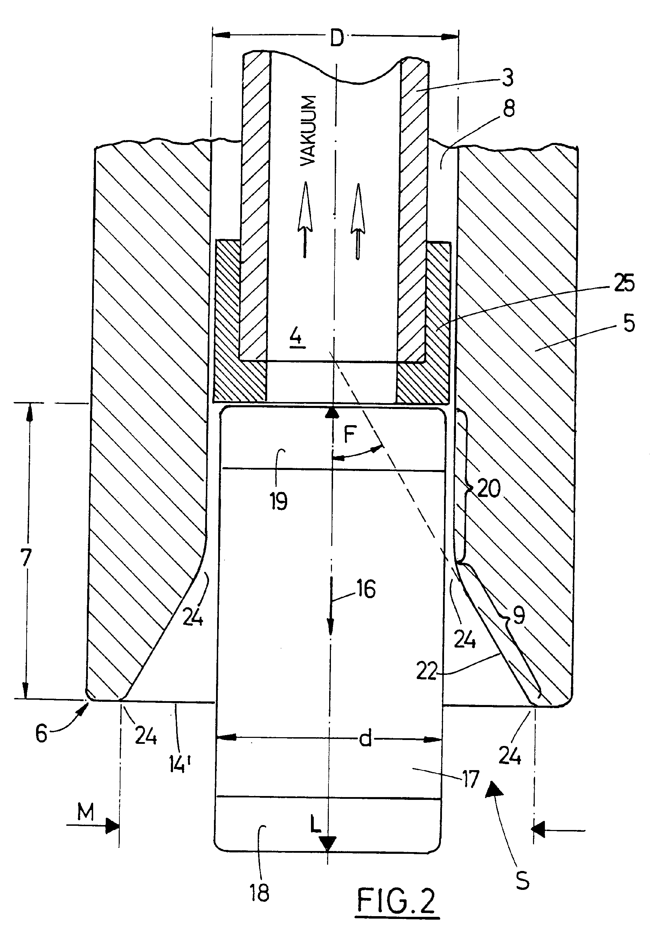

Der Aufbau und die detaillierte Ausgestaltung des erfindungsgemäßen Manipulatorkopfes ist in Fig. 1 und 2 dargestellt. Dabei wurde in Fig. 1 der Deutlichkeit halber die Halterung des Manipulatorkopfes an einer entsprechenden Bestückungsvorrichtung nicht dargestellt, da sie sich im Rahmen des üblichen Fachkönnens bewegt und beispielsweise aus DE-A-37 21 226 entnehmbar ist.

Der Kopfträger 1 ist in Form eines Zylinderkörpers gestaltet, der koaxial eine Vakuumdurchührung 2 in Form einer Bohrung aufweist. Diese steht mit einer nicht dargestellten Vakuum-Anschlußleitung mit Vakuumpumpe in Verbindung.

In koaxialer Verlängerung der Vakuumdurchführung 2 und in Saugverbindung mit dieser ist an der Unterseite des Kopfträgers 1 die Vakuum-Saugpipette 3 befestigt, an deren trägerabseitiger Saugöffnung 4 ein elektronisches Bauelement während des Bestückungsvorganges einer Leiterplatte unter Vakuumeinfluß gehalten werden kann. Auf der Saugpipette 4 ist ein koaxial dazu verlaufendes Manipulationshilfsrohr 5 geführt, dessen Freiende 6 in Aufnahmestellung für ein Bauelement (Fig. 1,2,4A-D) über die Saugöffnung 4 der Saugpipette 3 um die Überstehlänge 7 hinaussteht. Die Rohröffnung 8 des Manipulationshilfsrohres 5 weist zum Freiende 6 hin einen sich trichterförmig öffnenden Innenprofilabschnitt 9 auf.

Der kopfträgerseitige Abschnitt 10 des Manipulationshilfsrohres 5 ist im Durchmesser durch eine stufenförmige Ringverbreiterung 11 vergrößert und in einer auf die Unterseite des Kopfträgers 1 aufgeschobenen und dort befestigten Führungshülse 12 verschiebbar geführt. Die Führungshülse 12 ist an ihrem unteren Ende eingezogen ausgebildet und läßt die Durchführungsöffnung 13 für das Manipulationshilfsrohr 5 bzw. die Saugpipette 3 frei. Zwischen der Innenseite der stufenförmigen Ringverbreiterung 11 und der unteren Stirnfläche 14 des Kopfträgers 1 ist eine Schraubendruckfeder 15 eingesetzt, die das Manipulationshilfsrohr 5 in Überstehrichtung 16 beaufschlagt.

Im folgenden wird die Geometrie des Manipulatorkopfes im Bereich seiner Spitze (S) (Fig. 2) näher erläutert. Dabei ist zu beachten, daß mit einer bestimmten Geometrie der Spitze S nur elektronische Bauelemente mit einer ganz bestimmten Dimensionierung gehandhabt werden können, die nur innerhalb enger Grenzen variieren darf. Als Beispiel sei ein sogenannter Mikromelf-Durchführungswiderstand 17 angegeben, der zylindrisch ausgebildet ist und an der Zylindergrund- bzw. Deckfläche kappenförmige Anschlußkontakte 18,19 aufweist. Seine Länge beträgt etwa 2,1 mm, sein Durchmesser 1,1 mm.

Folgende Geometrie wird an der Manipulatorspitze S verwendet: Die Überstehlänge 7 des Manipulationshilfsrohres 5 über die Saugöffnung 4 der Saugpipette 3 beträgt in der Aufnahmestellung für den Durchführungswiderstand 17 (Fig. 1,2,4A-D) etwa 2/3 der Baulänge des Durchführungswiderstandes 17, also etwa 1,4 mm. Wie aus Fig. 2 weiter deutlich wird, nimmt der zylinderförmige Innenprofilabschnitt 9 der Rohröffnung 8 des Manipulationshilfsrohres 5 nur etwa die Hälfte der Überstehlänge 7 ein. Es schließt sich nach innen ein Zylinderabschnitt 20 an, dessen Durchmesser geringfügig größer als der maximale Außendurchmesser des zu manipulierenden Durchführungswiderstandes 17 ist. Der Durchmesser D beträgt also beispielsweise 1,3 mm, womit bei einem Außendurchmesser d des Durchführungswiderstandes 17 von 1,1 mm durch den Zylinderabschnitt 20 eine seitliche Zentrierung des Durchführungswiderstandes 17 im Bereich von +/- 1 mm stattfindet. Weiterhin ist der Maximaldurchmesser M der Trichteröffnung 21 des Manipulationshilfsrohres 5 um etwa 10% kleiner als die Baulänge L des Durchführungswiderstandes 17. Er beträgt damit etwa 1,8 bis 1,9 mm. Der Flankenwinkel F zwischen der Trichterflanke 22 und der Rohrlängsachse 23 beträgt etwa 30°. Die Übergangsbereiche 24 zwischen der ringförmigen Stirnfläche 14' des Manipulationshilfsrohres 5 und der Trichterflanke 22 bzw. zwischen der Trichterflanke 22 und dem Zylinderabschnitt 20 sind verrundet.

Durch die vorstehend beschriebene Geometrie ergibt sich der Vorteil, daß die Bauelemente unbehindert und reibungsarm in die Rohröffnung 8 eingesaugt werden können, wobei in der in Fig. 2 gezeigten Bestückungsposition eine gute Zentrierung und Sicherung des Durchführungswiderstandes 17 gegen ein Verkippen stattfinden.

Anhand von Fig. 2 ist zusätzlich auf den Paßringaufsatz 25 hinzuweisen, der die Saugöffnung 4 der Saugpipette 3 bildet. Der Paßringaufsatz 25 ist in seinem Durchmesser derart bemessen, daß er das Manipulationshilfsrohr 5 neben seiner Führung in der Führungshülse 12 unter leichtem Gleitspiel zusätzlich im Bereich der Manipulatorspitze S führt.

Die Verschiebbarkeit des Manipultionshilfsrohres 5 gegenüber der Vakuumsaugpipette 3 bzw. dem Kopfträger 1 kommt beim Bestücken der Leiterplatte zum Tragen. Das Manipulationshilfsrohr 5 ist gegenüber der Saugpipette 3 um eine begrenzte Hubstrecke von etwa 80% der Überstehlänge entgegen der Überstehrichtung 16 verschiebbar. Die verfügbare Hubstrecke beträgt also etwa 1,1 mm. Die beiderseitige Begrenzung der Hubstrecke wird dabei durch Anschläge für den kopfträgerseitigen Abschnitt 10 des Manipulationshilfsrohres 5 in der Führungshülse 12 erzielt. Die Hubbegrenzung in Überstehrichtung 16 erfolgt durch den Anschlag der abgeschrägten Stufenkante 26 der stufenförmigen Ringverbreiterung 11 des Manipulationshilfsrohres 5 an die Innenseite der Führungshülse 12 in deren eingezogenem Bereich. Die Hubbegrenzung entgegen der Überstehrichtung 16 erfolgt durch den Anschlag des kopfträgerseitigen Endes des Manipulationshilfsrohres 5 an der Stirnfläche 14 des Kopfträgers 1. Die verfügbare Hubstrecke H ist also durch den freien Abstand zwischen dem Manipulationshilfsrohr 5 und dem Kopfträger 1 in der Aufnahmestellung (Fig. 1) des Manipulationshilfsrohres gegeben.

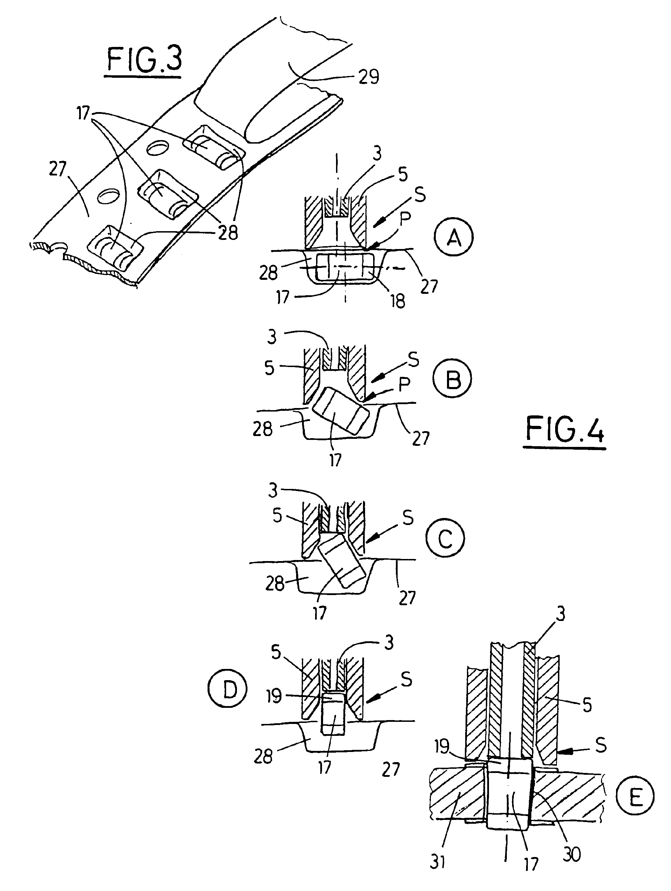

Anhand der Fig. 3 und 4 können die Manipulationsvorgänge, die mit dem erfindungsgemäßen Manipulatorkopf möglich sind, näher erläutert werden. In Fig. 3 ist ein Magazingurt 27 gezeigt, der Vertiefungen 28 mit den darin einliegenden Durchführungswiderständen 17 aufweist. Zum Versand sind die Vertiefungen 28 durch eine Abdeckfolie 29 verschlossen. Zur Entnahme jeden Widerstandes 17 wird die Manipulatorspitze S mit dem Manipulationshilfsrohr 5 in Aufnahmestellung (Fig. 4A) jeweils im Bereich einer Vertiefung 28 auf den Magazingurt 27 aufgesetzt. Durch das Aufsetzen wirkt das Manipulationshilfsrohr 5 auf den Kopfträger 1 zurück, womit beispielsweise über einen Berührungsschalter das Vakuum zur Beaufschlagung der Saugpipette 3 eingeschaltet werden kann. Die Trichteröffnung 21 wird dabei mit ihrem Mittelpunkt außerhalb der Längsmitte des Widerstandes 17 aufgesetzt, so daß beim Ansaugen des Widerstandes 17 dessen eines Ende, etwa der Anschlußkontakt 18, an der Stirnfläche 14' des Manipulationshilfsrohres 5 einen Drehpunkt P findet (Fig. 4B), womit der Widerstand 17 unter einer weiteren Drehung (Fig. 4C) in die Rohröffnung 8 eingesaugt wird, bis er mit der Stirnfläche seines anderen Anschlußkontaktes 19 an der Saugöffnung 4 der Saugpipette 3 ansteht (Fig. 4D). Nun ist die Bauteillängsachse koaxial zur Rohrlängsachse 23 ausgerichtet und der Widerstand 17 zentriert sowie zuverlässig zum Transport in die Bestückungsposition festgehalten. Der Manipulatorkopf wird dann zu seiner Sollposition vertikal oberhalb der Durchkontaktierungsbohrung 30 in der Mehrschichtleiterplatte 31 verfahren. Anschließend wird er abgesenkt, bis zuerst der Anschlußkontakt 18 in die Durchkontaktierungsbohrung 30 eintritt. Anschließend schlägt die Stirnfläche 14 des Manipulationshilfsrohres 5 an der Oberseite der Leiterplatte 31 an. Bei einem weiteren Absenken des Manipulatorkopfes bleibt das Manipulationshilfsrohr 5 stehen, der Kopfträger 1 und die Saugpipette 3 schieben sich unter weiterem Eindringen des Widerstandes 17 in die Durchkontaktierungsbohrung 30 bis zum Durchmessen der voll verfügbaren Hubstrecke H zwischen dem Manipulationshilfsrohr 5 und dem Kopfträger 1 bzw. der Saugpipette 3 weiter vor. In der in Fig. 4E gezeigten Einschubendstellung ist der Widerstand 17 durch die Abstimmung der Hubstrecke H und der Überstehlänge 7 auf die Bauteillänge L und die Leiterplattendicke 1 automatisch in seine Sollposition in der Leiterplatte 31 eingeschoben. Durch den Anschlag des Manipulationshilfsrohres 5 an der Leiterplatte 31 wird über die Schraubendruckfeder 15 eine Gegenkraft auf den Kopfträger 1 erzeugt, über die ein entsprechendes Schaltelement zum Ausschalten des Vakuums und Freigeben des Widerstandes 17 betätigt werden kann. Nach dem Abheben der Manipulatorspitze S von der Leiterplatte 31 fährt das Manipulationshilfsrohr 5 durch den Einfluß der Schraubendruckfeder 15 in die in Fig. 1,2 und 4A-D gezeigte Aufnahmestellung für das nächste Bauelement in Überstehrichtung 16 vor.

### Bezugszeichenliste

- 1: Kopfträger
- 2: Vakuumdurchführung
- 3: Vakuumsaugpipette
- 4: Saugöffnung
- 5: Manipulationshilfsrohr
- 6: Freiende
- 7: Überstehlänge
- 8: Rohröffnung
- 9: Innenprofilabschnitt
- 10: kopfträgerseitiger Abschnitt
- 11: stufenförmige Ringverbreiterung
- 12: Führungshülse
- 13: Durchführungsöffnung
- 14,14': Stirnfläche
- 15: Schraubendruckfeder
- 16: Überstehrichtung
- 17: Durchführungswiderstand
- 18,19: Anschlußkontakt
- 20: Zylinderabschnitt
- 21: Trichteröffnung
- 22: Trichterflanke
- 23: Rohrlängsachse
- 24: Übergangsbereich
- 25: Paßringaufsatz
- 26: Stufenkante
- 27: Magazingurt
- 28: Vertiefung
- 29: Abdeckfolie
- 30: Durchkontaktierungsbohrung
- 31: Mehrschichtleiterplatte
- S: Manipulatorspitze
- D: Durchmesser
- d: Außendurchmesser
- M: Maximaldurchmesser
- L: Baulänge
- F: Flankenwinkel
- H: Hubstrecke
- l: Leiterplattendicke
- P: Drehpunkt

## Patentansprüche

1. Manipulatorkopf für einen Handmanipulator oder eine halb- oder vollautomatische Bestückungsvorrichtung jeweils zur Manipulation von miniaturisierten elektronischen Bauelementen, insbesondere zum Bestücken von Mehrschichtleiterplatten mit sogenannten Durchführungswiderständen (17) in der Insert/Inboard-Mount-Technologie mit
- einem Kopfträger (1), der
-- als Handgriff ausgestaltet oder an der Bestückungsvorrichtung gehalten werden kann,
-- mit einer Vakuumanschlußleitung und
-- einer Vakuumdurchführung (2) versehen ist und
- einer mit der Vakuumdurchführung (2) in Verbindung stehenden Vakuum-Saugpipette (3) am Kopfträger (1), an deren Saugöffnung (4) das Bauelement (17) während des Bestückungsvorganges unter Vakuumeinfluß gehalten werden kann,
dadurch gekennzeichnet,
daß auf der Saugpipette (3) ein koaxial dazu verlaufendes Manipulationshilfsrohr (5) relativ zur Saugpipette (3) verschiebbar geführt ist, dessen Freiende (6) in Aufnahmestellung für das Bauelement (17) über die Saugöffnung (4) der Saugpipette (3) hinausssteht und dessen Rohröffnung (8) zum Freiende (6) hin einen sich trichterförmig öffnenden Innenprofilabschnitt (9) aufweist.

2. Manipulatorkopf nach Anspruch 1 mit einem Bauelement (17),
dadurch gekennzeichnet,
daß die Überstehlänge (7) des Manipulationshilfsrohres (5) über die Saugöffnung (4) der Saugpipette (3) etwa 50 bis 80%, vorzugsweise etwa 2/3 der Baulänge (L) des zu manipulierenden Bauelementes (17) beträgt.

3. Manipulatorkopf nach Anspruch 1 oder 2,
dadurch gekennzeichnet,
daß das Innenprofil des Manipulationshilfsrohres (5) im Bereich seiner Überstehlänge (7) ausgehend von der Saugöffnung (4) der Saugpipette (3) auf etwa der halben Überstehlänge (7) zylindrisch ausgebildet ist und sich an diesen Zylinderabschnitt (20) der sich trichterförmig öffnende Innenprofilabschnitt (9) anschließt.

4. Manipulatorkopf nach einem der vorgenannten Ansprüche mit einem Bauelement (17),
dadurch gekennzeichnet,
daß der Maximaldurchmesser (M) der Trichteröffnung (21) am Manipulationshilfsrohr (5) geringfügig, vorzugsweise um etwa 10% kleiner ist als die Baulänge (L) des zu manipulierenden Bauelementes (17).

5. Manipulatorkopf nach einem der vorgenannten Ansprüche,
dadurch gekennzeichnet,
daß der Flankenwinkel (F) zwischen der Trichterflanke (22) und der Rohrlängsachse (23) etwa 30° beträgt.

6. Manipulatorkopf nach einem der Ansprüche 3 bis 5,
dadurch gekennzeichnet,
daß die Übergangsbereiche (24) am Innenprofil des Manipulationshilfsrohres (5) zwischen dessen Stirnfläche (14') und Trichterflanke (22) sowie dessen Trichterflanke (22) und Zylinderabschnitt (20) verrundet sind.

7. Manipulatorkopf nach einem der Ansprüche 3 bis 5 mit einem Bauelement (17),
dadurch gekennzeichnet,
daß der Durchmesser (D) des Zylinderabschnittes (20) im Bereich der Überstehlänge (7) geringfügig größer als der maximale Außendurchmesser (d) des zu manipulierenden Bauelementes (17) ist.

8. Manipulatorkopf nach einem der vorgenannten Ansprüche,
dadurch gekennzeichnet,
daß das Manipulationshilfsrohr (5) entgegen seiner Überstehrichtung (16) über die Pipetten-Saugöffnung (4) um eine begrenzte Hubstrecke (H) relativ zur Saugpipette (4) verschiebbar ist.

9. Manipulatorkopf nach Anspruch 8,
dadurch gekennzeichnet,
daß die verfügbare Hubstrecke (H) geringer als die Überstehlänge (7) ist.

10. Manipulatorkopf nach Anspruch 9,
dadurch gekennzeichnet,
daß die verfügbare Hubstrecke (H) etwa 80% der Überstehlänge (7) entspricht.

11. Manipulatorkopf nach einem der vorgenannten Ansprüche,
dadurch gekennzeichnet,
daß der kopfträgerseitige Abschnitt (10) des Manipulationshilfsrohres (5) in einer Führungshülse (12) am Kopfträger (1) verschiebbar geführt ist.

12. Manipulatorkopf nach Anspruch 11,
dadurch gekennzeichnet,
daß in der Führungshülse (12) zur Begrenzung der verfügbaren Hubstrecke (H) Anschläge für das Manipulationshilfsrohr (5) angeordnet sind.

13. Manipulatorkopf nach Anspruch 11 oder 12,
dadurch gekennzeichnet,
daß in der Führungshülse (12) zwischen Kopfträger (1) und Manipulationshilfsrohr (5) ein Federelement (Schraubendruckfeder 15) zur Beaufschlagung des Manipulationshilfsrohres (5) in Überstehrichtung (16) angeordnet ist.

14. Manipulatorkopf nach einem der vorgenannten Ansprüche,
dadurch gekennzeichnet,
daß die Saugöffnung (4) der Saugpipette (3) von einem Paßringaufsatz (25) gebildet ist, der das diesen umgebende Manipulationshilfsrohr (5) unter Gleitspiel zusätzlich führt.

15. Manipulatorkopf nach einem der vorgenannten Ansprüche,
dadurch gekennzeichnet,
daß im Bereich der Überstehlänge (7) der Rohröffnung (8) des Manipulationshilfsrohres (5) zusätzliche Zentrierungs- und Klemmittel für die zu manipulierenden Bauelemente (17) vorgesehen sind.

## Claims

1. A manipulator head for a manual manipulator or a semi-automatic or fully automatic insertion device, in each case for the manipulation of miniaturized electronic components, in particular for the equipment of multilayer printed circuit boards with so-called lead-through resistors in the insert/ inboard mounting technology with
- a head carrier (1) which
-- can be designed as a handle or be held on the insertion device,
-- is provided with a vacuum connection line and
-- a vacuum duct (2) and
- a vacuum suction pipette (3) on the head carrier (1) which communicates with the vacuum duct (2), at the suction opening (4) of which pipette the component (17) can be held during the insertion process under the vacuum effect,
characterized in that
on the suction pipette (3) there is carried an auxiliary manipulation tube (5) extending coaxially thereto, for displacement relative to the suction pipette (3), the free end (6) of which tube projects in the position for taking up the component (17) beyond the suction opening (4) of the suction pipette (3) and whose tube opening (8) has an inner profile section (9) opening towards the free end (6) in the manner of a funnel.

2. A manipulator head according to claim 1 with a component (17),
characterized in that
the length (7) by which the auxiliary manipulation tube (5) projects beyond the suction opening (4) of the suction pipette (3) amounts to approximately 50 to 80%, preferably to approximately 2/3 of the overall length (L) of the component (17) to be manipulated.

3. A manipulator head according to claim 1 or 2,
characterized in that
the inner profile of the auxiliary manipulation tube (5) is in the zone of its projecting length (7), starting from the suction opening (4) of the suction pipette (3), designed to be cylindrical over approximately half the projecting length (7), and that the inner profile section (9) which opens up in the manner of a funnel, joins up with this cylindrical section (20).

4. A manipulator head according to one of the above mentioned claims with a component (17),
characterized in that
the maximum diameter (M) of the funnel opening (21) on the auxiliary manipulation tube (5) is slightly smaller, preferably approximately 10% smaller, than the overall length (L) of the component (17) to be manipulated.

5. A manipulator head according to one of the above mentioned claims,
characterized in that
the flank angle (F) between the funnel flank (22) and the longitudinal tube axis (23) amounts to approximately 30°.

6. A manipulator head according to one of claims 3 to 5,
characterized in that
the transition zones (24) on the inner profile of the auxiliary manipulation tube (5) between its front face (14') and the funnel flank (22), as well as its funnel flank (22) and cylindrical section (20,) are rounded off.

7. A manipulator head according to one of claims 3 to 5 with a component (17),
characterized in that
the diameter (D) of the cylindrical section (20) is in the zone of the projecting length (7) slightly larger than the maximum outer diameter (d) of the component (17) to be manipulated.

8. A manipulator head according to one of the above mentioned claims,
characterized in that
the auxiliary manipulation tube (5) is displaceable over the pipette suction opening (4) against its projecting direction (16) by a limited displacement path (H) relative to the suction pipette (3).

9. A manipulator head according to claim 8,
characterized in that
the available displacement path (H) is smaller than the projecting length (7).

10. A manipulator head according to claim 9,
characterized in that
the available displacement path (H) corresponds to approximately 80% of the projecting length (7).

11. A manipulator head according to one of the above mentioned claims,
characterized in that
the section (10) of the auxiliary manipulation tube (5) on the side of the head carrier is carried for displacement in a guide sleeve (12) on the head carrier (1).

12. A manipulator head according to claim 11,
characterized in that
in the guide sleeve (12) stops are arranged for the auxiliary manipulation tube (5) for limiting the available displacement path (H).

13. A manipulator head according to claim 11 or 12,
characterized in that
in the guide sleeve (12), a spring element (a helical compression spring 15) is arranged between the head carrier (1) and the auxiliary manipulation tube (5) for loading the auxiliary manipulation tube (5) in the projecting direction (16).

14. A manipulator head according to one of the above mentioned claims,
characterized in that
the suction opening (4) of the suction pipette (3) is formed by an attached ring adaptor (25) which additionally guides the auxiliary manipulation tube (5) surrounding the latter with sliding play.

15. A manipulator head according to one of the above mentioned claims,
characterized in that
in the zone of the projecting length (7) of the tube opening (8) of the auxiliary manipulation tube (5), provision is made for additional centering and clamping means for the components (17) to be manipulated.

## Revendications

1. Tête manipulatrice pour un manipulateur manuel ou un dispositif de garnissage semi-automatique ou entièrement automatique, prévu pour manipuler des composants électroniques miniaturisés, en particulier pour garnir des plaquettes de circuit imprimé multicouches de résistances dites de traversée (17) selon la technologie "insérer/monter à l'intérieur", tête comportant
- un porte-tête (1) qui
-- peut être conçu sous forme d'une poignée ou être tenu sur le dispositif de garnissage,
-- est muni d'une conduite de raccordement au vide et
-- d'un passage pour le vide (2) et
- comportant aussi, sur le porte-tête (1), une pipette d'aspiration sous vide (3) qui est en liaison avec le passage pour le vide (2) et à l'ouverture d'aspiration (4) de laquelle le composant (17) peut être tenu sous l'influence du vide pendant le processus de garnissage,
tête caractérisée
par le fait que sur la pipette d'aspiration (3) peut coulisser par rapport à la pipette d'aspiration un tube auxiliaire de manipulation (5) qui est orienté coaxialement à la pipette, dont, en position de réception du composant (17), l'extrémité libre (6) déborde au-delà de l'ouverture d'aspiration (4) de la pipette et dont l'ouverture tubulaire (8) présente, en direction de l'extrémité libre (6), un tronçon (9) à profil intérieur s 'ouvrant en forme d'entonnoir.

2. Tête manipulatrice selon la revendication 1, avec un composant (17), caractérisée par le fait que la longueur de débordement (7) du tube auxiliaire de manipulation (5) au-delà de l'ouverture d'aspiration (4) de la pipette (3) vaut environ 50 à 80%, de préférence environ 2/3 de la longueur hors-tout (L) du composant à manipuler (17).

3. Tête manipulatrice selon la revendication 1 ou 2, caractérisée par le fait que le profil intérieur du tube auxiliaire de manipulation (5), dans la zone de sa longueur de débordement (7) en partant de l'ouverture d'aspiration (4) de la pipette (3), est, sur environ la moitié de sa longueur de débordement (7), de forme cylindrique et par le fait qu'à ce tronçon cylindrique (20) se raccorde le tronçon (9) à profil intérieur s'ouvrant en forme d'entonnoir.

4. Tête manipulatrice selon l'une des revendications précédentes, avec un composant (17), caractérisée par le fait que le diamètre maximal (M) de l'ouverture de l'entonnoir (21) au tube auxiliaire de manipulation (5) est légèrement, de préférence d'environ 10%, inférieur à la longueur hors-tout (L) du composant à manipuler (17).

5. Tête manipulatrice selon l'une des revendications précédentes, caractérisée par le fait que le demi-angle au sommet (F) entre la surface latérale (22) de l'entonnoir et l'axe longitudinal (23) du tronçon tubulaire vaut environ 30°.

6. Tête manipulatrice selon l'une des revendications 3 à 5, caractérisée par le fait que les zones de transition (24) du profil intérieur du tube auxiliaire de manipulation (5), entre sa surface frontale (14') et la surface latérale de l'entonnoir (22), ainsi qu'entre cette surface latérale de l'entonnoir (22) et le tronçon cylindrique (20) sont arrondies.

7. Tête manipulatrice selon l'une des revendications 3 à 5 avec un composant (17), caractérisée par le fait que le diamètre (D) du tronçon cylindrique (20) est, dans la zone de sa longueur débordante (7), légèrement supérieur au diamètre extérieur maximal (d) du composant à manipuler (17).

8. Tête manipulatrice selon l'une des revendications précédentes, caractérisé par le fait que le tube auxiliaire de manipulation (5) peut coulisser, sur une course limitée (H), par rapport à la pipette d'aspiration (4), en direction opposée à la direction (16) dans laquelle il déborde au-delà de l'ouverture (4) d'aspiration de la pipette.

9. Tête manipulatrice selon la revendication 8, caractérisée par le fait que la course disponible (H) est inférieure à la longueur de débordement (7).

10. Tête manipulatrice selon la revendication 9, caractérisée par le fait que la course disponible (H) correspond à environ 80% de la longueur de débordement (7).

11. Tête manipulatrice selon l'une des revendications précédentes, caractérisée par le fait que le tronçon (10) du tube auxiliaire de manipulation (5) situé du côté du porte-tête peut coulisser dans une douille de guidage (12) montée sur le porte-tête (1).

12. Tête manipulatrice selon la revendication 1, caractérisée par le fait que dans la douille de guidage (12), pour limiter la course disponible (H), sont disposées des butées pour le tube auxilaire de manipulation (5).

13. Tête manipulatrice selon la revendication 11 ou 12, caractérisée par le fait que dans la douille de guidage (12), entre porte-tête et tube auxiliaire de manipulation (5) est disposé un élément élastique (ressort de compression hélicoïdal 15) pour contraindre le tube auxiliaire de manipulation (5) dans sa direction de débordement (16).

14. Tête manipulatrice selon l'une des revendications précédentes, caractérisée par le fait que l'ouverture d'aspiration (4) de la pipette (3) est formée d'une garniture annulaire ajustée (25) qui guide en outre, à ajustement glissant, le tube auxiliaire de manipulation (5) qui entoure cette garniture.

15. Tête manipulatrice selon l'une des revendications précédentes, caractérisée par le fait que dans la zone de la longueur en débordement (7) de l'ouverture tubulaire (8) du tube auxiliaire de manipulation (5) sont prévus des moyens supplémentaires de centrage et de bridage pour les composants à manipuler.
